**Europäisches Patentamt**

(19) **European Patent Office**

**Office européen des brevets**

(11) Veröffentlichungsnummer: **0 056 434**

**B1**

# (12) EUROPÄISCHE PATENTSCHRIFT

(45) Veröffentlichungstag der Patentschrift:
10.06.87

(51) Int. Cl.⁴: **G 11 C 11/24**

(21) Anmeldenummer: **81108591.9**

(22) Anmeldetag: **20.10.81**

(54) **Monolithisch integrierter Halbleiterspeicher.**

(30) Priorität: **21.01.81 DE 3101802**

(43) Veröffentlichungstag der Anmeldung:
**28.07.82 Patentblatt 82/30**

(45) Bekanntmachung des Hinweises auf die Patenterteilung:
**10.06.87 Patentblatt 87/24**

(84) Benannte Vertragsstaaten:
**DE FR GB**

(56) Entgegenhaltungen:
**DE-B-2 647 394**
**US-A-3 983 544**
**US-A-4 118 794**

**IBM TECHNICAL DISCLOSURE BULLETIN, Band 22,
Nr. 8B, Januar 1980, Seiten 3738-3739, New York, US.
L. ARZUBI u.a.: "Bit line cascading in
semiconductor storage chips"**

(73) Patentinhaber: **Siemens Aktiengesellschaft Berlin
und München, Wittelsbacherplatz 2, D-8000
München 2 (DE)**

(72) Erfinder: **Hoffmann, Kurt, Dr.- Ing., Nelkenweg 20,
D-8021 Taufkirchen (DE)**

## Beschreibung

Die Erfindung bezieht sich auf einen monolithisch integrierten Halbleiterspeicher mit einer Matrix aus zeilen- und spaltenweise angeordneten und einander gleichen Speicherzellen in Gestalt jeweils eines MOS-Feldeffekttransistors und einer z.B. durch einen MOS-Kondensator gegebenen Speicherkapazität, bei dem jeder Matrixspalte je ein Komparator und eine ebenfalls durch eine Speicherzelle der genannten Art gegebene Vergleichszelle zugeordnet ist.

Speicherschaltungen dieser Art sind z.B. in "IEEE Journal of Solid-State Circuits" Vol. SOC-7 (Oct. 1972), S. 336- 340, beschrieben.

Bei der üblichen Organisation solcher dynamisch betriebener Schreib-Lesespeicher ist jeder Spalte der Speichermatrix je eine zeilenparallel verlaufende und mit den in der betreffenden Matrixspalte vorgesehenen Speicherzellen verbundene Bitleitung vorgesehen, die an den einen Eingang eines durch eine bistabile Kippstufe gegebenen Komparators angeschlossen ist. Am zweiten Signaleingang des Komparators liegt dann die Vergleichszelle.

Sowohl die Speicherzelle als auch die Vergleichszelle sind als sogenannte Ein-Transistor-Speicherzellen ausgebildet. Sie bestehen demnach aus einem Transfertransistor (gewöhnlich vom Anreicherungstyp), dessen Source bzw. Drain an der zugehörigen Bitleitung und dessen Gate an der der betreffenden Speicherzelle zugeordneten (zeilenparallel verlaufenden) Wortleitung angeschlossen ist. Der Drain bzw. die Source des Transfer- oder Schalttransistors liegt am einen Pol einer, insbesondere durch eine MOS-Kapazität gegebenen Speicherkondensator, dessen zweiter Pol an das Bezugspotential der Schaltung gelegt ist. Für die Vergleichszelle ist eine den Wortleitungen entsprechende und gleichzeitig mit diesen zu adressierende Dummy-Leitung vorgesehen, während die Source- bzw. der Drain ihres Transfertransistors mit dem anderen informationsführenden Anschluß des Komparators verbunden ist. Im übrigen entspricht die Schaltung der Vergleichs- oder Dummyzelle den Verhältnissen bei den Ein-Transistor-Speicherzellen.

Häufig wird man im Interesse der Reduktion der Wirkung der Bitleitungskapazität auf das Speicherverhalten und die Funktionsgeschwindigkeit des Matrixspeichers die Bitleitung der einzelnen Matrixspalten sowie die der betreffenden Matrixspalte zugeordnete Anzahl der Ein-Transistor-Speicherzellen in zwei Hälften unterteilen und die eine Hälfte dem einen und die andere Hälfte dem anderen der bereits genannten Signaleingänge des Komparators zuordnen. Jede der beiden Bitleitungshälften wird mit je einer Vergleichszelle in der beschriebenen Weise versehen, die dann jeweils über ihre Gates adressiert werden, wenn eine Adressierung einer der anderen Bitleitungshälfte zugeordneten Ein-Transistor-Speicherzelle vorliegt.

Wie erkannt wurde, bestehen weitere Möglichkeiten, den Einfluß der Bitleitungskapazität auf die Funktionsgeschwindigkeit des Matrixspeichers zu reduzieren.

Die Bitleitungskapazität $C_B$ ist eine parasitäre Kapazität, die sich nicht nur auf die Betriebsgeschwindigkeit, sondern auch auf die Amplitude des jeweils ausgelesenen Signals im ungünstigen Sinne auswirkt. Es ist deshalb das Ziel der Erfindung, der Bitleitungskapazität $C_B$ Rechnung zu tragen. Zu bemerken ist dabei, daß die erfindungsgemäße Maßnahme nicht nur an einer Bitleitung sondern in den meisten Fällen an sämtlichen Bitleitungen des erfindungsgemäßne Matrixspeichers vorgenommen wird.

Diese Aufgabe wird gelöst durch die kennzeichnenden Merkmale des Patentanspruchs 1.

Erfahrungsgemäß ist die effektive Bitleitungskapazität umso größer, je weiter die Speicherzelle vom Komparator, d.h. vom Leseverstärker, entfernt ist. Dieser Tatsache trägt die Erfindung Rechnung.

Aus der DE-B 26 47 394 ist ein Halbleiterspeicher bekannt mit mehreren Zellenfeldern, die hintereinander geschaltet sind. Jedes Zellenfeld weist eigene, ihm zugeordnete Bitleitungen auf. Die Abkopplung eines ersten Zellenfeldes von einem nachgeschalteten zweiten Zellenfeld erfolgt dabei mittels Schalttransistoren. Diese schalten im Lesebetrieb jedoch je Bitleitung nach dem Bewerten das bereits ausgewertete und verstärkte Signal zum nächsten, zweiten Zellenfeld weiter. Durch die Aufteilung einer Speicherzellenmatrix in einzelne Zellenfelder, die je Bitleitung jeweils einen eigenen Komparator aufweisen, wird in Verbindung mit Schalttransistoren, die je Speicherzellenfeld zwischen Ausgängen der Komparatoren und entsprechenden Bitleitungen des benachbarten, nachgeschalteten Speicherzellenfeldes angeordnet sind, ermöglicht, daß Bitleitungen innerhalb eines Speicherzellenfeldes verringerte Kapazitäten aufweisen. Es ist jedoch ein Mehraufwand an Komparatoren erforderlich.

Schalttransistoren an Bitleitungen sind ebenfalls bekannt aus der US-A 3,983,544. Gegenstand dieses Patentes ist ein Halbleiterspeicher, bestehend aus einem RAM-Anteil und einem (wesentlich größeren) ROM-Anteil, wobei beide Anteile über gemeinsame Bitleitungen dieselben Bewerterschaltungen benützen. Der ROM-Anteil vird dabei beim Betrieb des Speichers als RAM-Speicher über Transistoren bitleitungsmäßig vom RAM-Anteil abgetrennt so daß die Kapazitäten der noch mit den Bewerterschaltungen verbundenen Bitleitungteile verringert sind. Die Verringerung der Bitleitungskapazitäten betrifft jedoch einen Halbleiterspeicher mit verschiedenartigen Speicherzellen, nicht einen solchen mit gleichartigen Speicherzellen.

Aus der US-A 4,118,794 ist bekannt, Speicherzellen am Rande eines Speicherzellenfeldes mit einer größeren Speicherkapazität auszustatten. Dies dient jedoch ausschließlich der Kompensation von Leckstromverlusten, die dynamische Speicherzellen am Zellenfeldrand naturgemäß in höherem Maße aufweisen als solche im Innenbereich des Zellenfeldes. Dies hat keinerlei Auswirkungen auf die Bitleitungskapazitäten.

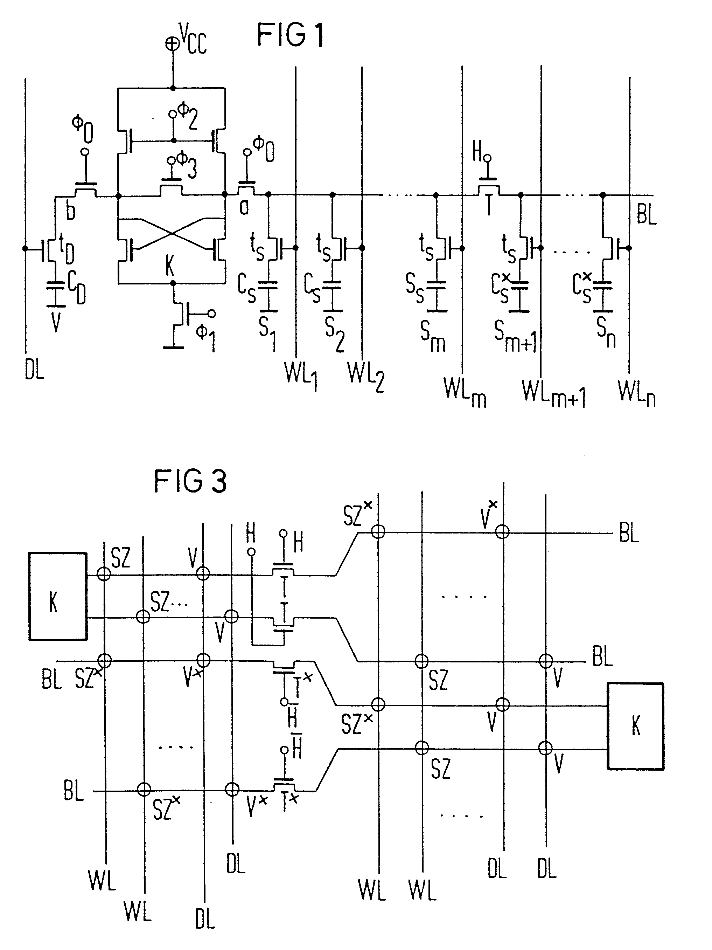

Die Erfindung wird nun anhand der Figuren 1 bis 3 näher beschrieben.

Wie aus Fig. 1 ersichtlich ist die Bitleitung BL zwischen der m-ten Speicherzelle $S_m$ und der folgenden Speicherzelle $S_{m+1}$ unterbrochen und an der Unterbrechungsstelle ein Schalttransistor T vorgesehen, der vom Typ der Schalttransistoren $t_s$ in den Eintransistorspeicherzellen, also vorwiegend vom n-Kanal-Anreicherungstyp, ist. Bei Anwesenheit eines entsprechenden Signals H an seinem Gate schließt der Schalttransistor T die Unterbrechungsstelle und schaltet damit die weiter vom Leseverstärker K entfernt angeordneten Speicherzellen $S_{m+1},....S_n$ an den Komparator K an.

Wird nun eine der Speicherzellen $S_1$ bis $S_m$ adressiert, so kann durch entsprechende Steuerung der Schalttransistors T der betreffenden Bitleitung BL der Rest dieser Bitleitung BL und damit die Speicherzellen $S_{m+1},...S_n$ vom Komparator abgetrennt werden, so daß der für die Adressierung dann maßgebende Teil der Bitleitung bezüglich der effektiven Bitleitungskapazität $C_B$ merklich reduziert ist. Dadurch wird das Lesesignal größer, als dies der Fall wäre, wenn die Unterbrechung der Bitleitung BL durch den Schalttransistor T nicht effektiv geworden wäre.

Wird hingegen eine der Speicherzellen $S_{m+1}$ bis $S_n$ ausgelesen, so muß durch entsprechende Steuerung des Schalttransistors T der abseits des Komparators K liegende Bitleitungsabschnitt mit den Speicherzellen $S_{m+1}$ usw. wieder an den Leseverstärker K angeschlossen werden, so daß wieder die erhöhte Bitleitungskapazität $C_B$ effektiv ist.

Um nun auch hier eine Verbesserung des Lesesignals zu erhalten, wird nach der Erfindung vorgeschlagen, daß die Speicherkapazität $C_s$ in den Speicherzellen $S_{m+1},....S_n$ größer als die Speicherkapazität $C_s$ in den inneren Zellen $S_1$ bis $S_m$ bemessen wird.

Es ist verständlich, daß die einzelnen Bitleitungen BL auch mehr als nur eine über je einen Schalttransistor T überbrückbare Unterbrechungsstellen aufweisen können. Da für gewöhnlich die Zahl der einer Bitleitung BL zugeordneten Speicherzellen $S_i$ für alle Matrixspalten gleich ist, wird man zweckmäßig die Unterbrechungsstellen und damit die zugehörigen Transistoren T in zeilenparallel verlaufenden Reihen anordnen und die zu den einzelnen dieser Reihen gehörenden Schalttransistoren T durch ein gemeinsames Signal H steuern.

An sich können die einzelnen Schalttransistoren T sowohl durch einen Transistor vom Anreicherungstyp als auch durch einen Transistor vom Verarmungstyp realisiert sein, was übrigens auch für die Transistoren $t_s$ bzw. $t_D$ der Speicherzeilen und der Vergleichszeilen V gilt. Die Verwendung von Transistoren vom Anreicherungstyp, die simultan mit den übrigen Transistoren des Speichers hergestellt werden, hat neben fertigungstechnischen Vorteilen noch folgende Vorteile.

Häufig sind nämlich die Bitleitungen BL durch an der Oberfläche des den Speicher aufnehmenden Halbleiterplättchens durch entsprechend geformte Dotierungzonen realisierte Leitbahnen gegeben, die zugleich die Source-Bereiche der der betreffenden Bitleitung BL zugeordneten Ein-Transistor-Speicherzellen $S_1$, $S_2$,.... bilden. An den einzelnen Unterbrechungsstellen wird man dann den die betreffende Bitleitung BL darstellenden Kanal durch einen Bereich vom entgegengesetzten Leitungstyp (also vom Leitungstyp des Substrats) unterbrechen und auf einer oberhalb der Unterbrechungsstelle vorzusehenden Gate-Oxydschicht die Gateelektrode des für die Überbrückung der Unterbrechungsstelle vorzusehenden Schalttransistors T anordnen. Source und Drain dieses Schalttransistors T sind durch die beiden beiderseits der Unterbrechungsstelle liegenden Teile der Bitleitung BL gegeben. Die Unterbrechungsstelle wird dann bei entsprechender Signalbeaufschlagung dieser Gateelektrode in der bei MOS-Feldeffekttransistoren vom Anreicherungstyp bekannten und allgemein angewendeten Weise überbrückt.

Jede der Speicherzellen $S_1$ bis $S_n$ der aus Fig. 1 ersichtlichen Ausgestaltung weist einen über die zugehörige Wortleitung $WL_i$ zu betätigenden Transfer- oder Schalttransistor $t_s$ und einen mit diesem in Serie liegenden Speicherkondensator $C_s$ auf. Bei der in gleicher Weise aufgebauten Vergleichszelle V hat man den Transfertransistor $t_D$ und die Speicherkapazität $C_D$. Bei der oben angegebenen Möglichkeit zur Verbesserung der aus den Zellen $S_{m+1}$ bis $S_n$ stammenden Lesesignale werden die Speicherkapazitäten $C_s$ in den Zellen $S_{m+1},...S_n$ größer als in den Zellen $S_1$ bis $S_m$ eingestellt. Als weitere Verbesserung der Erfindung wird dann zweckmäßig neben der in Fig. 1 dargestellten Vergleichszelle V noch eine zweite Vergleichszelle (in Fig. nicht dargestellt) vorgesehen, deren Speicherkapazität $C_D$ nicht der Speicherkapazität $C_s$ der inneren Speicherzellen $S_1$ bis $S_m$ sondern der vergrößerten Speicherkapazität $C^*_s$ der äußeren Speicherzellen $S_{m+1}$ bis $S_n$ entspricht. Diese zusätzliche Speicherzelle wird dann an den Komparator K geschaltet, sobald eine der Zellen $S_{m+1}$ bis $S_n$ adressiert und der

Überbrückungstransistor T der betreffenden Bitleitung leitend ist.

Der als Leseverstärker vorgesehene Komparator K ist in üblicher Weise als dynamischer Flip-Flop-Verstärker ausgebildet, dessen einer Eingang a an der mit den Speicherzellen $S_1$ bis $S_n$ versehenen Bitleitung BL und deren anderer Eingang an die Vergleichszelle V bzw. an die zusätzliche Vergleichszelle mit vergrößerter Speicherkapazität $C^*_D$ angeschlossen ist. Die Vergleichszelle V besteht aus dem Transistor $t_D$ und der Speicherkapazität $C_D$ bzw. $C^*_D$ und wird über je eine ihr zugeordnete und den Wortleitungen $WL_1$ bis $WL_n$ der Ein-Transistor-Speicherzellen $S_1$ bis $S_n$ entsprechende Adressierleitung DL aktiviert. Die für die Adressierung und Aktivierung der einzelnen Teile des Komparators K dienenden Signale $\Phi_0$, $\Phi_1$, $\Phi_2$, $\Phi_3$ sind ebenso wie der Aufbau des Komparators K bekannt und für die Erfindung keinesfalls spezifisch. Vielmehr kann jeder für dynamische Speicher übliche Leseverstärker als Komparator K eingesetzt werden. Von einer weiteren Beschreibung des Komparators K wird deshalb ebenfalls abgesehen.

Die Adressierung der einzelnen Speicherzellen $S_i$ über die zeilenparallelen Wortleitungen $W_i$ ist so auszugestalten, daß bei der Adressierung einer Speicherzelle $S_i$, die von dem Komparator K durch eine oder mehrere Unterbrechungsstellen der zugehörigen Bitleitung BL separiert sind, die jeweils adressierte Speicherzelle unmittelbar mit dem Leseverstärker die erforderliche Verbindung erhält. Es müssen also mit anderen Worten die an den Unterbrechungsstellen zwischen der jeweils adressierten Speicherzelle $S_i$ und dem Komparator K vorgesehenen Schalttransistoren T rechtzeitig adressiert werden, so daß die besagten Unterbrechungsstellen aufgehoben sind.

Zu diesem Zweck kann man z.B. die der Adressierung der Wortleitungen $WL_{m+1}$ bis $WL_n$ dienenden Ausgänge des der Zeilenadressierung dienenden Dekodierers an je einen Eingang eines ODER-Gatters legen, dessen Ausgang das zur Steuerung des Schalttransistors T erforderliche Signal nur dann liefert, wenn eine der Speicherzellen $S_{m+1}$ bis $S_n$ durch ein vom Dekodierer geliefertes Signal adressiert wird. Wird hingegen eine der inneren Wortleitungen $WL_1$ bis $WL_m$ adressiert, so erscheint am Ausgang des ODER-Gatters kein Signal (d.h. eine logische "0") so daß der äußere Teil der Bitleitung BL vom inneren Teil und damit vom Komparator K getrennt bleibt. Sind mehrere solche Unterbrechungsstellen pro Bitleitung BL vorgesehen, so können mehrere solche ODER-Gatter vorgesehen werden, wobei das - vom Komparator aus gesehen - der zweiten Unterbrechungsstelle zugeordnete ODER-Gatter sowohl von den Dekoderausgängen, die den Wortleitungen $WL_{n+1}$ bis $WL_p$ (p = Nummer der letzten Wortleitung vor der zweiten Unterbrechungsstelle) zugeordnet sind, gesteuert ist. Der Ausgang dieses zweiten ODER-Gatters ist dann zur Steuerung sowohl des Schalttransistors T an der ersten Unterbrechungsstelle als auch zur Steuerung des Schalttransistors T an der zweiten Unterbrechungsstelle vorgesehen.

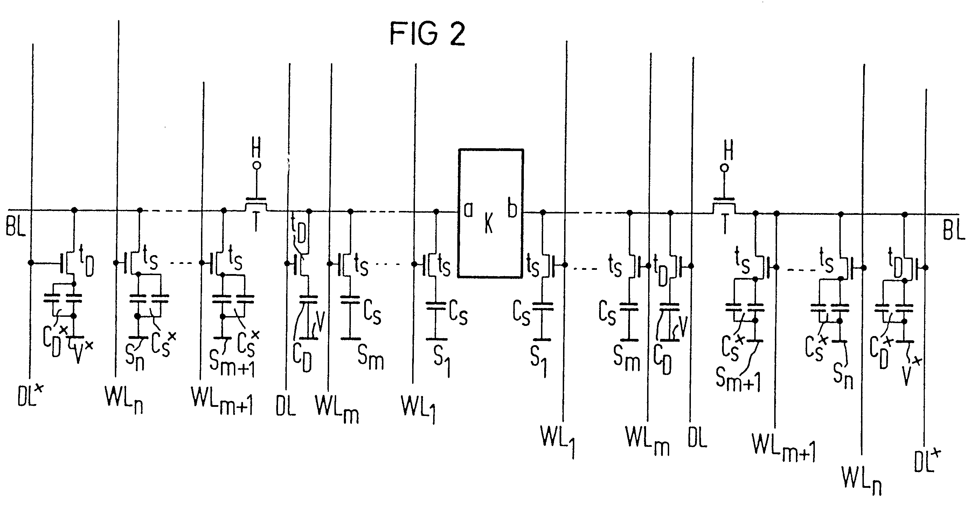

Wie bereits oben dargelegt, entspricht es dem Stande der Technik an beiden informationsführenden Anschlüssen a und b des Komparators K der einzelnen Matrixspalten sowohl SSpeicherzellen $S_i$ als auch Vergleichszellen V vorzusehen. Eine entsprechende Ausgestaltung einer Speicheranordnung gemäß der Erfindung ist in Figur 2 dargestellt, wobei die die Speicherkspazitäten $C^*_s$ der äußeren Speicherzellen $S_{m+1}$ bis $S_n$ durch die Parallelschaltung zweier Kondensatoren symbolisiert dargestellt ist. Es ist klar, daß bei der Ausgestaltung gemäß Fig. 2 die - ebenfalls mit einer vergrößerten Speicherkapazität $C^*_s$ ausgerüsteten - Vergleichszellen $V^*$ in den äußeren Teilen der Bitleitung BL lediglich durch eine entsprechende Beaufschlagung der ihnen jeweils zugeordneten Dummyleitungen DL zu aktivieren sind, so daß hier eine Vereinfachung gegenüber der Ausgestaltung gemäß Fig. 1 erreicht ist.

Eine weitere Verbesserung des erfindungsgemäßen Speichers ist in Figur 3 gezeigt. Diese Möglichkeit geht von einem Stand der Technik aus, wie er in der US-PS 4,044,340 bzw. in der Literaturstelle "1980 IEEE International Solid-State Circuits Conference", S. 228/229 beschrieben ist. Bei solchen Speicheranordnungen werden die von den beiden Signalanschlüssen a und b des Komparators K ausgehenden Bitleitungshälften nicht spiegelbildlich zur Symmetrielinie der Komparatorschaltung divergierend wie bei der Anordnung gemäß Figur 2 sondern parallel zueinander und zu dieser Symmetrieachse geführt.

Wendet man bei einem solchen Speicher die erfindungsgemäße Unterteilung der Bitleitungen an, so empfiehlt es sich, wie aus Figur 3 ersichtlich, die Komparatoren K abwechselnd entlang den beiden zeilenparallel verlaufenden Begrenzungen der Speichermatrix anzuordnen. Dies eröffnet die Möglichkeit, die näher an dem jeweils zugeordneten Komparator K angeordneten Speicherzellen bzw. Vergleichszellen V mit kleinerer Speicherkapazität $C_D$ und damit Chip-Fläche und die im äußeren Bereich aller Bitleitungen BL liegenden Zellen mit entsprechend größerer Speicherkapazität und damit Chip-Fläche auszustatten, ohne daß der Platzbedarf für die Gesamtmatrix im Vergleich zu den bekannten Ausgestaltungen vergrößert wird.

Bei der in Figur 3 dargestellten Ausführung eines dynamischen Schreib-Lesespeichers gemäß der Erfindung geht man somit nicht von konträr zueinander verlaufenden Bitleitungen sondern von parallel zueinander verlaufenden Bitleitungen BL aus. Diese Anordnung hat den Vorteil, daß die Speicherzellen $S_1$ bis $S_m$ mit kleinerer Speicherkapazität $C_s$ und damit kleinerer Chip-Fläche ausgestaltet und die übrigen Speicherzellen $S_{m+1}$ bis $S_n$ mit größerer Speicherkapazität $C^*_s$ und damit mit größerer Chip-Fläche ausgestaltet werden können, ohne daß dabei der Gesamtbedarf an Chip-Fläche für die Speichermatrix gesteigert zu werden braucht.

Die Ansteuerung der jeweils benachbart zueinander angeordneten Bitleitungspaaren und der zu ihnen gehörenden Komparatoren geschieht über dieselben Wortleitungen WL bzw. Dummy-Leitungen DL. Man muß nur dafür sorgen, daß die nicht adressierten Bitleitungen bzw. Bitleitungsabschnitte ausgeschaltet bleiben. Aus diesem Grund erfolgt die Ansteuerung der zu jeweils benachbarten Bitleitungspaaren gehörenden Schalttransistoren an den einander entsprechenden Unterbrechungsstellen mit zueinander invertierten Signalen. Bei der aus Fig. 3 ersichtlichen Darstellung bedeutet dies, daß die Schalttransistoren T des ersten Bitleitungspaares durch ein Signal H gegeben ist, während die zum zweiten Bitleitungspaar gehörenden Schalttransistoren T* an den Unterbrechungsstellen der beiden Leitungen BL des zweiten Bitleitungspaares durch ein Signal H̄ gesteuert sind, welches zui Steuersignal H des ersten Schalttransistorpaares T invertiert ist. Bei der in Fig. 3 gebrachten Darstellung ist für die Speicherzeilen die Bezeichnung SZ bzw. SZ* und für die Vergleichszellen die Bezeichnung V bzw. V* sowie eine vereinfachte Darstellung verwendet worden.

**Patentansprüche**

1.) Monolithisch integrierter Halbleiterspeicher mit einer Matrix aus zeilen und spaltenweise angeordneten und einander gleichartigen Speicherzellen in Gestalt jeweils eines MOS-Feldeffekttransistors und einer Speicherkapazität, insbesondere eines MOS-Kondensators, bei dem jeder Matrixspalte je ein Komparator und eine ebenfalls durch eine Speicherzelle der genannten Art gegebene Vergleichszelle zugeordnet ist, dadurch gekennzeichnet, daß wenigstens zwischen zwei benachbarten Speicherzellen ($S_m$, $S_{m+1}$) wenigstens einer Matrixspalte der Verlauf der zugehörigen Bitleitung (BL) unterbrochen ist, daß die Unterbrechungsstelle über die stromführende Strecke eines MOS-Feldeffekttransistors (T) überbrückbar ist, und daß die Speicherkapazitäten ($C_s$) der außerhalb der Unterbrechungsstelle vorgesehenen Speicherzellen größer sind als die Speicherkapazitäten der zwischen dem Komparator (K) und der Unterbrechungsstelle in der Bitleitung (BL) vorgesehenen Speicherzellen.

2) Halbleiterspeicher nach Anspruch 1, dadurch gekennzeichnet, daß die in der Speichermatrix vorgesehenen Bitleitungen dieselbe Anzahl von Unterbrechungsstellen sowie Speicherzellen aufweisen, daß dabei die einander entsprechenden Unterbrechungsstellen zeilenparallel angeordnet sind und die diesen Unterbrechungsstellen jeweils zugeordneten MOS-Feldeffekttransistoren (T) durch ein gemeinsames Signal (H) aktivierbar sind.

3.) Halbleiterspeicher nach einem der Ansprüche 1 bis 2, dadurch gekennzeichnhet, daß die Aktivierung der die einzelnen Unterbrechungsstellen in den Bitleitungen (BL) überbrückenden MOS-Feldeffekttransistoren (T) durch die Adressierung jeder durch die besagte Unterbrechungsstelle vom zugehörigen Komparator (K) getrennte Speicherzelle ($S_i$) bzw. Vergleichszelle (V, V*) auslösbar ist.

4.) Halbleiterspeicher nach Anspruch 3, dadurch gekennzeichnet, daß die der Adressierung der zu den außerhalb der Unterbrechungsstellen in den Bitleitungen (BL) liegenden Speicherzellen ($S_{m+1},...S_n$) bzw. Vergleichszellen (V*) führenden Wortleitungen bzw. Dummy-Leitungen (WL bzw. DL) dienenden Ausgänge des die Matrix steuernden Zeilendekodierers über wenigstens ein ODER-Gatter zur Steuerung des Schaltschalttransistors (T) an den die betreffende Speicherzellen von dem jeweils zugeordneten Komparator (K) trennenden Unterbrechungstellen der einzelnen Bitleitungen vorgesehen sind.

5.) Halbleiterspeicher nach einem der Ansprüche 1 bis 4, dadurch gekennzeichnet, daß sämtliche in der Speichermatrix vorgesehenen Transistoren einschließlich der Transistoren an den Unterbrechungsstellen der Bitleitungen (BL) der Speichermatrix vom Anreicherungstyp sind.

6.) Halbleiterspeicher nach einem der Ansprüche 1 bis 5, dadurch gekennzeichnet, daß jedem Bitleitungsabschnitt je eine Vergleichszelle (V bzw. V*) zugeordnet ist, deren Speicherkapazität ($C_D$) der Speicherkapazität ($C_s$) der zu dem betreffenden Bitleitungsabschnitt gehörenden Speicherzellen entspricht.

7.) Halbleiterspeicher nach einem der Ansprüche 1 bis 6, dadurch gekennzeichnet, daß jedem der beiden informationsführenden Anschlüssen (a, b) der einzelnen Komparatoren (K) je eine Bitleitung (BL) zugeordnet ist und daß diese Bitleitungen in einander gleicher Weise mit Speicherzellen, Vergleichszellen und Unterbrechungsstellen versehen sind.

8.) Halbleiterspeicher nach Anspruch 7, dadurch gekennzeichnet, daß die beiden von den einzelnen Komparatoren (K) ausgehenden Bitleitungen (BL) in zueinander entgegengesetzten Richtungen verlaufen.

9.) Halbleiterspeicher nach Anspruch 7, dadurch gekennzeichnet, daß die einzelnen von den Komparatoren (K) ausgehenden Bitleitungen (BL) parallel zueinander nach derselben Richtung geführt sind.

10.) Halbleiterspeicher nach Anspruch 9, dadurch gekennzeichnet, daß die durch wenigstens eine Unterbrechungsstelle nebst zugehörigem Schalttransistor (T bzw. T*) vom zugehörigen Komparator (K) getrennten Abschnitte der Bitleitungen einen größeren Abstand voneinander als die unmittelbar än den Komparatoren (K) liegenden Bitleitungsabschnitte aufweisen.

11.) Haltbleiterspeicher nach einem der Ansprüche 7 bis 10, dadurch gekennzeichnet, daß die geometrische Anordnung der Komparatoren (K) inbezug auf das ihnen zugehörige Bitleitungspaar (BL) derart getroffen ist, daß die zu jeweils benachbarten Bitleitungspaaren gehörenden Komparatoren (K) jeweils sich an einander gegenüberliegenden Teilen der Begrenzung der Speichermatrix liegen.

12.) Halbleiterspeicher nach einem der Ansprüche 7 bis 11, dadurch gekennzeichnet, daß den zu den durch wenigstens eine Unterbrechungsstelle vom zugehörigen Komparator (K) gehörenden Bitleitungsabschnitten gehörenden Speicherzellen (SZ*) bzw. Vergleichszellen (V*) ein größerer Teil an Halbleiteroberfläche als den übrigen Speicherzellen (SZ) bzw. Vergleichszellen (V) zugeteilt ist.

13.) Halbleitersmeicher nach Anspruch 11, dadurch gekennzeichnet, daß an jeder Kreuzungsstelle einer Wortleitung (WL) mit sämtlichen Bitleitungen (BL) je eine Speicherzelle (SZ bzw. SZ*) vorgesehen ist und daß die zu jeweils benachbarten Bitleitungspaaren gehörenden Schalttransistoren an den einander entsprechenden Unterbrechungsstellen der jeweils benachbarten Bitleitungspaare zu einander invertiert gesteuert sind.

14.) Halbleiterspeicher nach einem der Ansprüche 1 bis 13, dadurch gekennzeichnet, daß die Bitleitungen durch dotierte Kanäle an der Oberfläche des den Speicher aufnehmenden Siliciumplättchens gegeben sind, daß die Unterbrechungsstellen durch jeweils einen den entgegengesetzten Leitungstyp zu dem Kanal aufweisenden Abschnitt (Substrat) gegeben sind, und daß an den einzelnen Unterbrechungsstellen der zugehörige Schalttransistor (T bzw. T*) derart realisiert ist, daß die beiden durch die Unterbrechungsstelle voneinander getrennten Bitleitungsabschnitte mit Source bzw. Drain des zugehörigen Schalttransistors (T bzw. T*) identisch sind.

## Claims

1. A monolithic integrated semiconductor store comprising a matrix of storage cells of the same type arranged in rows and columns which each consist of a MOS field-effect transistor and a storage capacitor, in particular a MOS capacitor, where each matrix column is assigned a comparator and a comparator cell which consists of a storage cell of the aforesaid type, characterised in that between at least two adjacent storage cells ($S_m$, $S_{m+1}$) of at least one matrix column the associated bit line (BL) is interrupted, that the interruption point can be bridged via the current-carrying path of a MOS field-effect transistor (T), and that the storage capacitances ($C_s$) of the storage cells unaffected by the bit-line interruption are greater than the storage capacitances of the storage cells located between the comparator (K) and the interruption point in the bit line (BL).

2. A semiconductor store as claimed in Claim 1, characterised in that the bit lines in the store matrix have the same number of interruption points and storage cells, that the mutually-corresponding interruption points are row-parallel arranged, and that the respective MOS field-effect transistors (T) assigned these interruption points can be activated by a common signal (H).

3. A semiconductor store as claimed in one of Claims 1 to 2, characterised in that the activation of the MOS field-effect transistors (T) which bridge the individual interruption points in the bit lines (BL) can be triggered by addressing each storage cell ($S_i$) or comparator cell, (V or V* as the case may be) separated from the associated comparator (K) by the aforesaid interruption point.

4. A semiconductor store as claimed in Claim 3, characterised in that those outputs of the row decoder controlling the matrix which serve to address the word lines and dummy lines (WL and DL) to those storage cells ($S_{m+1}$,...$S_n$) or comparator cells (V*) as the case may be, located outside the interruption points in the bit lines (BL), serve via at least one OR-gate, to control the switching transistor (T) at the interruption points of the individual bit lines which separate the respective storage cells from the respective assigned comparator (K).

5. A semiconductor store as claimed in one of Claims 1 to 4, characterised in that all the transistors contained in the store matrix, including the transistors located at the interruption points of the bit lines (BL) of the store matrix, are of the enhancement type.

6. A semiconductor store as claimed in one of Claims 1 to 5, characterised in that each bit line section is assigned a comparator cell (V or V* as the case may be), the storage capacitance ($C_D$) of which corresponds to the storage capacitance ($C_s$) of the storage cells assigned to the respective bit line section.

7. A semiconductor store as claimed in one of Claims 1 to 6, characterised in that each of the two information-carrying terminals (a, b) of the individual comparators (K) is assigned a bit line (BL) and that these bit lines are provided with storage cells, comparator cells, and interruption points in identical fashion.

8. A semiconductor store as claimed in Claim 7, characterised in that the two bit lines (BL) which commence from the individual comparators (K) extend in mutually-opposite directions.

9. A semiconductor store as claimed in Claim 7, characterised in that the individual bit lines (BL) from the comparators (K) extend parallel to one
another in the same direction.

10. A semiconductor store as claimed in Claim
9, characterised in that those bit line sections
which are separated from the associated
comparator (K) by at least one interruption point
and associated switching transistor (T or T* as
the case may be) are spaced from one another by
a greater interval than those bit line sections
arranged directly adjacent the comparators (K).

11. A semiconductor store as claimed in one of
Claims 7 to 10, characterised in that the
geometric arrangement of the comparators (K) in
relation to the pair of bit lines (BL) which they are
assigned is such that the comparators (K)
assigned to adjacent pairs of bit lines are each
located at mutually-opposite parts of the
boundary of the store matrix.

12. A semiconductor store as claimed in one of
Claims 7 to 11, characterised in that those
storage cells (SZ*) or comparator cells (V*) as the
case may be, assigned to the bit line sections
separated from the associated comparator (K) by
at least one interruption point are allocated a
larger proportion of the semiconductor surface
than the remaining storage cells (SZ) or
comparator cells (V) as the case may be.

13. A semiconductor store as claimed in Claim
11, characterised in that a storage cell (SZ or SZ*
as the case may be) is arranged at each
intersection point of a word line (WL) with all the
bit lines (BL) and that the switching transistors,
assigned to adjacent pairs of bit lines, at the
mutually-corresponding interruption points of the
adjacent pairs of bit lines are controlled in
inverted fashion relative to one another.

14. A semiconductor store as claimed in one of
Claims 1 to 13, characterised in that the bit lines
consist of doped channels on the surface of the
silicon disc which accommodates the store, that
the interruption points each consist of a
(substrate) section which has the opposite
conductivity type to the channel, and that at the
individual interruption points the associated
switching transistor (T or T* as the case may be)
is constructed such that the two bit line sections
separated by the interruption point are
respectively identical to the source and drain of
the associated switching transistor (T or T* as the
case may be).

**Revendications**

1. Mémoire intégrée monolithique à
semiconducteurs comportant une matrice formée
de cellules de mémoire identiques entre-elles et
disposées suivant des lignes et des colonnes et
se présentant chacune sous la forme d'un
transistor à effet de champ MOS et d'une
capacité de stockage, notamment un
condensateur MOS, et dans laquelle à chaque
colonne de la matrice se trouvent associés
respectivement un comparateur et une cellule de comparaison constituée également par une
cellule de mémoire du type indiqué, caractérisée
par le fait qu'au moins entre deux cellules de
mémoire voisines (Sm, Sm+1) d'au moins une
colonne de matrice, la ligne associée de
transmission de bits (BL) est interrompue, que le
point d'interruption peut être shunté par la voie
d'alimentation en courant d'un transistor à effet
de champ MOS (T) et que les capacités de
stockage (Cs) des cellules de mémoire prévues à
l'extérieur du point d'interruption sont
supérieures aux capacités de stockage des
cellules de mémoire prévues entre le
comparateur (K) et le point d'interruption de la
ligne de transmission de bits (BL).

2. Mémoire à semiconducteurs suivant la
revendication 1, caractérisée par le fait que les
deux lignes de transmission de bits prévues dans
la matrice de mémoire, possèdent le même
nombre de points d'interruption qu'il y a de
cellules de mémoire, que les points
d'interruption, qui se correspondent
réciproquement, sont disposés dans des lignes
parallèles et que les transistors à effet de champ
MOS (T) associés respectivement à ces points
d'interruption peuvent être activés par un signal
commun (H).

3. Mémoire à semiconducteurs suivant l'une
des revendications 1 à 2, caractérisée par le fait
que l'activation des transistors à effet de champ
(T) shuntant les différentes points de
transmission dans les lignes de transmission de
bits (BL) est déclenchée par l'adressage de
chaque cellule de mémoire (Si) ou de chaque
cellule de comparaison (V, V*) séparée du
comparateur associé (K) par ledit point
d'interruption.

4. Mémoire à semiconducteurs suivant la
revendication 3, caractérisée par le fait que les
sorties, qui servent à réaliser l'adressage des
lignes de transmission de mots ou des lignes
fictives (WL ou DL) qui aboutissent aux cellules
de mémoire (Sm+1...Sn) ou aux cellules de
comparaison (V*) situées à l'extérieur des points
d'interruption présents dans les lignes de
transmission de bits (BL), du décodeur de lignes
commandant la matrice sont raccordées par
l'intermédiaire d'au moins une porte OU utilisée
pour la commande du transistor de commutation
(T) aux points d'interruption des différentes
lignes de transmission de bits, qui séparent les
cellules de mémoire concernées du comparateur
(K) respectivement associé.

5. Mémoire à semiconducteurs suivant l'une
des revendications 1 à 4, caractérisée par le fait
que tous les transistors prévus dans la matrice de
mémoire y compris les transistors présents au
niveau des points d'interruption des lignes de
transmission de bits (BL) de la matrice de
mémoire sont du type à enrichissement.

6. Mémoire à semiconducteurs suivant l'une
des revendications 1 à 5, caractérisée par le fait
qu'à chaque section d'une ligne de transmission
de bits est associée respectivement une cellule
de comparaison (V ou V*), dont la capacité de stockage ($C_D$) correspond à la capacité de stockage ($C_s$) des cellules de mémoire appartenant à la section considérée de lignes de transmission.

7. Mémoire à semiconducteurs suivant l'une des revendications 1 à 6, caractérisée par le fait qu'une ligne respective de transmission de bits (BL) est associée à chacune des deux bornes (a, b) véhiculant les informations, des différents comparateurs (K) et que ces lignes de transmission de bits sont munies, de manière identique entre elles, de cellules de mémoire, de cellules de comparaison et de points d'interruption.

6. Mémoire à semiconducteurs suivant la revendication 7, caractérisée par le fait que les deux lignes de transmission de bits (BL), qui partent des différents comparateurs (K), s'étendent dans des directions réciproquement opposées.

9. Mémoire à semiconducteurs suivant la revendication 7, caractérisée par le fait que les différentes lignes de transmission de bits (BL) qui partent des comparateurs (K), s'étendent parallèlement les unes aux autres dans la même direction.

10. Mémoire à semiconducteurs suivant la revendication 9, caractérisée par le fait que les sections des lignes de transmission de bits, qui sont séparées par au moins un point d'interruption en dehors du transistor de commutation associé (T ou T*) par rapport au comparateur associé (K), sont à une distance réciproque plus importante que les sections de lignes de transmission de bits raccordées directement aux comparateurs (K).

11. Mémoire à semiconducteurs suivant l'une des revendications 7 à 10, caractérisée par le fait que la disposition géométrique des comparateurs (K) par rapport au couple de lignes de transmission de bits (BL), qui leur est associé, est choisie de telle sorte que les comparateurs (K) faisant partie des couples respectivement voisins des lignes de transmission de bits, sont situés respectivement dans des parties, disposées en vis-à-vis, de la limite de la matrice de mémoire.

12. Matrice à semiconducteurs suivant l'une des revendications 7 à 11, caractérisée par le fait qu'aux cellules de mémoire (SZ*) ou aux cellules de comparaison (V*), qui appartiennent aux sections de lignes de transmission de bits séparées du comparateur associé (K) par au moins un point d'interruption, se trouve associée une partie de la surface semiconductrice, plus importante que dans le cas des autres cellules de mémoire (SZ) ou des autres cellules de comparaison (B).

13. Mémoire à semiconducteurs suivant la revendication 11, caractérisée par le fait qu'une cellule respective de mémoire (SZ ou SZ*) est prévue en chaque point d'intersection d'une ligne de transmission de mots (WL) avec toutes les lignes de transmission de bits (BL) et que les transistors de commutation appartenant à des couples respectivement voisins des lignes de transmission de bits présents au niveau des points d'interruption qui se correspondent réciproquement, des couples de lignes de transmission de bits respectivement voisins sont commandés d'une manière inverse entre eux.

14. Mémoire à semiconducteurs suivant l'une des revendications 1 à 13, caractérisée par le fait que les lignes de transmission de bits sont formées par des canaux dopés présents à la surface de la plaquette en silicium recevant la mémoire, que les points d'interruption sont formés par une partie (substrat) possédant un type de conductivité opposé à celui du canal, et qu'au niveau des différents points d'interruption, le transistor de commutation associé (T ou T*) est réalisé de telle sorte que les deux sections de la ligne de transmission, séparées l'une de l'autre par le point d'interruption et comportant la source ou le drain du transistor de commutation associé (T ou T*), sont identiques.

FIG 1

FIG 3

FIG 2